(19) Europäisches Patentamt
European Patent Office
Office européen des brevets

(11) **EP 1 303 966 B1**

(12) **EUROPÄISCHE PATENTSCHRIFT**

(45) Veröffentlichungstag und Bekanntmachung des Hinweises auf die Patenterteilung:
**21.09.2005 Patentblatt 2005/38**

(51) Int Cl.⁷: **H04L 29/06**

(21) Anmeldenummer: **01955264.5**

(22) Anmeldetag: **20.07.2001**

(86) Internationale Anmeldenummer:
**PCT/DE2001/002740**

(87) Internationale Veröffentlichungsnummer:
**WO 2002/009386 (31.01.2002 Gazette 2002/05)**

(54) **HEADER-KOMPRESSIONSVERFAHREN FÜR NETZWERKPROTOKOLLE**

HEADER COMPRESSION METHOD FOR NETWORK PROTOCOLS

PROCEDE DE COMPRESSION D'EN-TETES POUR DES PROTOCOLES DE RESEAU

(84) Benannte Vertragsstaaten:
**AT BE CH CY DE DK ES FI FR GB GR IE IT LI LU MC NL PT SE TR**

(30) Priorität: **25.07.2000 DE 10036149**
**11.01.2001 DE 10101089**

(43) Veröffentlichungstag der Anmeldung:
**23.04.2003 Patentblatt 2003/17**

(73) Patentinhaber: **SIEMENS AKTIENGESELLSCHAFT**
**80333 München (DE)**

(72) Erfinder:
• **PANDEL, Jürgen**
**83620 Feldkirchen-Westerham (DE)**
• **KUTKA, Robert**
**82269 Geltendorf (DE)**
• **HUTH, Hans-Peter**
**80638 München (DE)**

(56) Entgegenhaltungen:
• **FARBER D J ET AL.: "A Thinwire Protocol for connecting personal computers to the INTERNET" IETF REQUEST FOR COMMENTS, September 1984 (1984-09), Seiten 1-22, XP002179551**
• **"SESSION HEADER COMPRESSION SCHEME USING DIFFERENTIAL RUN-LENGTH ENCODING" IBM TECHNICAL DISCLOSURE BULLETIN, IBM CORP. NEW YORK, US, Bd. 40, Nr. 12, 1. Dezember 1997 (1997-12-01), Seiten 125-126, XP000754111 ISSN: 0018-8689**
• **JACOBSON V: "Compressing TCP/IP Headers for Low-Speed Serial Links" IETF REQUEST FOR COMMENTS, Februar 1990 (1990-02), XP002139708**
• **CASNER S ET AL: "Compressing IP/UDP/RTP Headers for Low-Speed Serial Links" IETF REQUEST FOR COMMENTS, XX, XX, Februar 1999 (1999-02), Seiten 1-21, XP002164597**

**Beschreibung**

Die Erfindung betrifft ein Verfahren zur Kompression von Header-Informationen in Netzwerkprotokollen, ein Verfahren zur Dekomprimierung entsprechend komprimierter Header-Informationen sowie korrespondierende Encoder/Decoder und Sende/Empfangseinheiten.

Bereits seit geraumer Zeit besteht das Problem, dass die umfangreiche Header-Information von IP-Protokollen teuere Mobilfunkkanäle in besonderem Maße belastet. Eine Kompression dieser Header ist daher vor allem für eine Übertragung über drahtlose Verbindungen erwünscht.

Die Abkürzung IP steht dabei für Internet Protocol, ein Protokoll der TCP/IP-Familie auf Schicht 3 des OSI-Referenzmodells. IP ist für den verbindungslosen Transport von Daten vom Sender über mehrere Netze zum Empfänger zuständig, wobei keine Fehlererkennung oder -korrektur erfolgt, d.h. IP kümmert sich nicht um schadhafte oder verlorengegangene Pakete. IP wird von mehreren darüberliegenden Protokollen genutzt, hauptsächlich von TCP, aber auch von UDP.

Als zentrale datentragende Einheit wird im IP das Datagramm definiert, das eine Länge von bis zu 65535 Bytes haben kann. Zu übertragende Daten werden von Protokollen oberhalb von IP (etwa TCP oder UDP) entgegengenommen und vom Sender fragmentiert, d.h. in Datagramme zerlegt. Empfängerseitig werden diese wieder zusammengesetzt, wobei man von defragmentieren spricht. IP ist vom genutzten Medium unabhängig und gleichfalls für LANs (Local Area Networks) wie für WANs (Wide Area Networks) geeignet.

Als Header bezeichnet man dabei den Teil eines Datenpaketes, in dem keine Nutzdaten, sondern diverse Verwaltungsdaten enthalten sind, z.B. Adresse, Paketnummer, Senderkennung, Paketstatus etc. Die Daten zur Fehlererkennung bzw. zur Fehlerkorrektur (z.B. Checksummen CRC) werden in der Regel zu den Nutzdaten gezählt.

TCP ist ein verbindungsorientiertes Transportprotokoll, das eine logische Vollduplex-Punkt-zu-Punkt-Verbindung ermöglicht. Es stellt dabei sicher, dass Daten fehlerfrei und in der gewünschten Reihenfolge über ein darunterliegendes IP-Netz übertragen werden. Es erweitert das darunterliegende IP um Funktionen zur Datensicherung und Verbindungssteuerung.

UDP steht als Abkürzung für User Datagram Protocol und bezeichnet ein verbindungsloses Anwendungsprotokoll zum Transport von Datagrammen der IP-Familie. Es setzt - wie TCP auch - auf IP auf. Im Vergleich zum wesentlich häufiger verwendeten TCP verzichtet UDP auf Fehlererkennung und -korrektur, arbeitet daher aber schneller und verfügt über einen kleineren Header, weshalb der Overhead geringer und das Verhältnis von Anzahl Nutzdaten zu Paketlänge besser ist. UDP ist besser geeignet bei Anwendungen, die kurze Nachrichten versenden und diese notfalls komplett wiederholen können, oder bei Anwendungen, die in Echtzeit durchgeführt werden müssen (Sprach- oder Videoübertragung).

Die Anwendung kann bei speziellen Anwendungen, z.B. im Echtzeit-Bereich, bei der Fehlererkennung und Fehlerkorrektur von weiteren, speziellen Protokollen höherer Schichten unterstützt werden, z.B. dem RTP (Real-time Protocol). Das Grundprinzip von RTP ist die Nutzung von Forward Error Control. Dies wird durch einen erweiterten Header ermöglicht, in dem Zusatzinformationen stehen. Diese sind z.B. die Art der übertragenen Nutzdaten (Sprache, Bilddaten etc.) oder der Zeitpunkt der Erzeugung der Daten, wodurch die Daten einfacher in eine bestimmte korrekte Reihenfolge gebracht oder nach Ablauf einer bestimmten Zeit verworfen werden können.

Ein bekanntes Protokoll-Header-Kompressionsverfahren findet sich z.B. in S. Casner und V. Jacobson, "Compressing IP/UDP/RTP Headers for Low-Speed Serial Links", Network Working Group, Request for Comments:2508, Februar 1999; (einsehbar im Internet unter http://www.ietf.org/rfc/rfc2508.txt?number=2508).

Dabei werden verschiedene Codierungen für unterschiedliche Protokolle vorgeschlagen. So erfolgt eine separate Komprimierung für RTP Header von end-to-end-Verbindungen, während im Falle einer link-to-link-Verbindung eine gemeinsame Komprimierung von RTP/UDP/IP Headern möglich ist.

Vorgesehen ist dabei eine Codierung mit drei verschiedenen Code-Stufen:

-   ein kompletter Header (full header FH)
-   eine differentielle Codierung erster Ordnung (first order difference FO), nämlich die Beschreibung zweier aufeinanderfolgender Header durch einen variablen Längencode und
-   eine differentielle Codierung zweiter Ordnung (second order difference SO), also die Übertragung der Differenzen zweier FO-Header.

Für eine Komprimierung von TCP-Headern werden nach einmaligem Senden eines unkomprimierten Headers sich verändernde Felder durch eine differentielle Codierung beschrieben, um deren Größe zu reduzieren. Außerdem werden sich verändernde Felder komplett eliminiert, indem Änderungen anhand der Länge eines Paketes berechnet werden. Dies beruht auf der Erkenntnis, dass etwa die Hälfte der Bytes in IP- und TCP-Headern für die Dauer einer Verbindung unverändert bleiben.

Eine Komprimierung von RTP-Headern erfolgt auf ähnliche Weise, indem ein Decoder den kompletten Header anhand der FO-Information und SO-Information rekonstruiert. Außerdem wird die Entdeckung nutzbar gemacht, wonach trotz einiger geänderter Felder pro Datenpaket die Differenz von Paket zu Paket häufig konstant ist und daher die second order difference SO Null beträgt. In solchen Fällen werden lediglich ein unkomprimierter Header und die jeweiligen first order differences FO gespeichert und ein Hinweis mitgeteilt, dass die second order difference SO Null beträgt.

Aus dem Stand der Technik sind eine Vielzahl von Verfahren zur Kompression von Headerinformationen in unterschiedlichen Netzwerkprotokollen bekannt, wobei bei diesen Verfahren ein vollständiger Header beim Verbindungsaufbau als Referenz übertragen wird und eine Kodierung des jeweiligen aktuellen Headers durch Segmentieren in veränderte und unveränderte Felder erfolgt, wobei der aktuelle Header anschließend differenziell übermittelt wird. Solche Verfahren sind insbesondere aus folgenden Druckschriften bekannt:

Farber D.J. et al. "A Thinwire Protocol for connecting personal computers to the Internet", IETF REQUEST FOR COMMENTS, Sept. 1984 (1984-09), S. 1-22;

"SESSION HEADER COMPRESSION SCHEME USING DIFFERENTIAL RUN-LENGTH ENCODING", IBM TECHNICAL DISCLOSURE BULLETIN; IBM Corp., New York, US, Bd. 40, Nr. 12, 1. Dezember 1997 (1997-12-01), S. 125-126, ISSN: 0018-8689;

Jacobsen V: "Compressing TCP/IP Headers for Low Speed Serial Links", IETF REQUEST FOR COMMENTS, Febr. 1990 (1990-02).

Nachteilig dabei ist unter anderem, dass diese bekannten Komprimierungsverfahren auf bestimmte solche Protokolle spezialisiert sind und nur für diese funktionieren. Für die verschiedenen Varianten der Codierung einzelner Protokolle oder mehrerer gemeinsam, müssen jeweils verschiedene Encoder zur Verfügung stehen, was den Aufwand erhöht und sich negativ auf die Wirtschaftlichkeit auswirkt.

Die Aufgabe der vorliegenden Erfindung besteht deshalb darin, eine Möglichkeit zur Komprimierung von Header-Informationen zu schaffen, die unabhängig vom jeweiligen Protokolltyp gleichermaßen effizient einsetzbar und dadurch wirtschaftlicher ist.

Gemäß der vorliegenden Erfindung wird diese Aufgabe durch ein Verfahren zur Kompression von Header-Informationen in Netzwerkprotokollen mit den folgenden Schritten gelöst:

- Übertragung eines vollständigen Headers beim Verbindungsaufbau sowie senderseitige und empfängerseitige Verwendung dieses Headers als Referenz,
- Codierung durch senderseitiges Segmentieren jedes weiteren Headers in veränderte Felder und unveränderte Felder gegenüber dem jeweils vorangehenden Header, wobei ein zusammenhängender Bereich, der veränderte Symbole und Intervalle von höchstens m unveränderten Symbolen aufweist, als verändertes Feld klassifiziert wird und ein zusammenhängender Bereich von mindestens m+1 unveränderten Symbolen als unverändertes Feld klassifiziert wird,
- Prädizieren der Positionen dieser Felder von den Feldern des vorangehenden Headers,
- differentielle Übermittlung des aktuellen Headers, indem für jede prädizierte Position ein Merkmal übertragen wird, das signalisiert, ob sich eine Position geändert hat.

   Dabei hat es sich als günstig erwiesen, wenn für Intervalle von höchstens m unveränderten Symbolen zur Klassifizierung als verändertes Feld ein Wert m = 2 gewählt wird.

   Eine Weiterbildung zeichnet sich dadurch aus, dass im Bedarfsfall in vorgebbaren Abständen während einer Übertragung erneut ein vollständiger Header übermittelt wird, der senderseitig und empfängerseitig als neue Referenz dient.

   Nach einer weiter vorteilhaften Ausgestaltung wird neben jedem für eine prädizierte Position übertragenen Merkmal

- bei unveränderter Position im Fall eines veränderten Feldes der Inhalt des geänderten Teils dieses Feldes übertragen und
- bei veränderter Position im Fall eines veränderten Feldes oder eines unveränderten Feldes jeweils ein Längencode zur Beschreibung der Länge eines unveränderten Teils und/oder ein Längencode zur Beschreibung eines geänderten Teils sowie der Inhalt des geänderten Teils übertragen.

Dabei hat es sich als vorteilhaft erwiesen, wenn jedes für eine prädizierte Position übertragene Merkmal ein Bit ist und jeder Längencode die Länge des jeweiligen Bereichs eines Feldes in einer Anzahl von Bits angibt, die nach

$$[\log_2 (\text{Bereich} - m)]$$

bemessen ist.

Alternativ kann auch ein Byte als kleinste Codiereinheit dienen, wobei jedes.für eine prädizierte Position übertragene Merkmal ein Byte ist und Feldlängen in Einheiten von Bytes bestimmt werden. Dies führt in vielen Fällen zu kleineren Wertebereichen und damit zu einer effektiveren Codierung.

Wenn im Fall einer geänderten Position veränderte Felder um ein Nachbarsymbol ergänzt werden, falls eine Codierung dieses ergänzten Feldes weniger aufwendig ist, als eine Codierung der geänderten Position, so lässt sich die Effizienz weiter steigern.

Dies erfolgt vor allem dann vorteilhaft, wenn $[\log_2 (\text{Anzahl der zur Beschreibung der Feldlänge notwendigen Zahlen} - m)] >= 2$ ist.

Nach einer weiteren vorteilhaften Ausgestaltung des Verfahrens der vorliegenden Erfindung werden in einem zu übertragenden gesicherten Headerstrom enthaltene fehlererkennende und/oder fehlerkorrigierende Codes, insbesondere Checksummen, mitkomprimiert.

Wenn der komprimierte Datenstrom im Bedarfsfall um fehlererkennende und/oder fehlerkorrigierende Schutzmechanismen erweitert wird, so lässt sich die Übertragungssicherheit weiter steigern.

Darauf aufbauend erfolgt eine Dekompression von entsprechend der Erfindung komprimierten Header-Informationen in Netzwerkprotokollen, indem ein jeweiliger Header empfängerseitig anhand des Referenzheaders und der differentiell übertragenen Informationen folgender Header, umfassend für jede von den Feldern des vorangehenden Headers prädizierte Position ein Merkmal, das signalisiert, ob sich die Position geändert hat, rekonstruiert wird.

Das voranstehend geschilderte Verfahren nach der Erfindung lässt sich besonders vorteilhaft in entsprechenden Encodern und Decodern einsetzen, die wiederum bevorzugt als Bestandteile von Sende- oder Empfangseinheiten, z.B. in mobilen Kommunikationsendgeräten, zum Einsatz gelangen können.

Das Verfahren nutzt unter anderem die Tatsache, dass in Protokoll-Headern lange zusammenhängende Bereiche unverändert bleiben und häufig die Position der sich ändernden Bereiche unverändert bleibt. In diesen Fällen brauchen die Positionen nicht übermittelt zu werden.

Dieser erfindungsgemäße Ansatz ermöglicht sowohl die Kompression einzelner Protokolle (z.B.: RTP bei end-to-endVerbindung) oder mehrerer verschachtelter Protokolle (IP/UDP/RTP, bei link-to-link-Verbindung). Ebenso lässt er sich auf getunnelte Protokolle (also die Verschachtelung mehrerer IP-Header) unmittelbar und ohne Änderung des Codierverfahrens anwenden.

Weitere Vorteile und Details der Erfindung ergeben sich anhand der folgenden umfassenden Darstellung und in Verbindung mit den Figuren. Es zeigen im einzelnen:

FIG 1    einen Datenauszug in Form eines hexadezimalen Listings von RTP/UDP/IP-Headern zur Darstellung statistischer Veränderungen,

FIG 2    eine Prinzipdarstellung einer Folge von Headern zur Veranschaulichung der Codierung von veränderten und unveränderten Feldern und

FIG 3    eine Prinzipdarstellung des Codes für die Feldlänge.

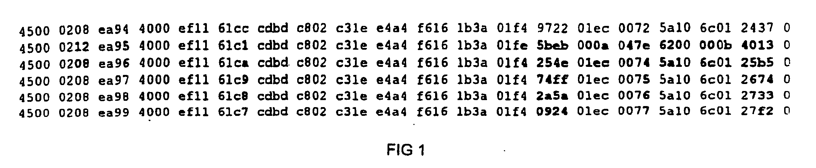

Das vorgeschlagene Codierverfahren gemäß der Erfindung nutzt statistische Eigenschaften von beliebigen Netzprotokollen, ohne spezielles Wissen über die Bedeutung einzelner Protokoll-Felder zu benötigen. Netzprotokolle besitzen im allgemeinen lange zusammenhängende Bereiche, die unverändert bleiben. Auch beinhalten viele Felder den Wert Null. Veränderte Felder sind häufig in Intervallen gruppiert, die eine lange Distanz zueinander aufweisen. Die Darstellung in FIG 1 zeigt dies anhand eines beispielhaften Listings mit hexadezimalen Daten von mehreren aufeinanderfolgenden RTP/UDP/IP-Headern, die zeilenweise aufgeführt sind. Die fett gedruckten Zahlenwerte stellen veränderte Informationen dar, während die übrigen unverändert bleiben.

Solche unveränderten Bereiche werden daher aus dem vorherigen Header prädiziert und brauchen nicht übertragen zu werden. Zusätzlich wird die Position der veränderten und unveränderten Felder prädiziert, so dass die Übermittlung der Positionskoordinaten in den meisten Fällen eingespart werden kann. Dieses Prinzip bewirkt eine hohe Datenkompression, da nur die sich ändernden Daten und ein geringer Overhead gesendet werden muss.

Das Verfahren läuft im Detail wie folgt ab:

Zur Initialisierung beim Verbindungsaufbau und wenn nötig in bestimmten Abständen wird ein gesamter Header vollständig übertragen.

Anschließend erfolgt eine differentielle Codierung, indem die folgenden Headers differentiell übermittelt werden. Encoder und Decoder bewahren den vollständigen vorangegangenen Header als Bezugsgröße in einem Referenzspeicher auf.

Dazu wird der aktuelle Header zunächst in veränderte und unveränderte Felder wie folgt segmentiert:

Ein zusammenhängender Bereich von Bits, die sich gegenüber dem Vorgänger-Header verändert haben und Intervalle von höchstens m unveränderten Bits besitzen, wird als verändertes Feld oder c-Feld c-F klassifiziert. Kurze unveränderte Intervalle der Länge m werden in die c-Felder eingeschlossen, da eine separate Codierung ineffektiv ist (siehe dazu den folgenden Absatz). Ein geeigneter Wert ist hierbei m = 2.

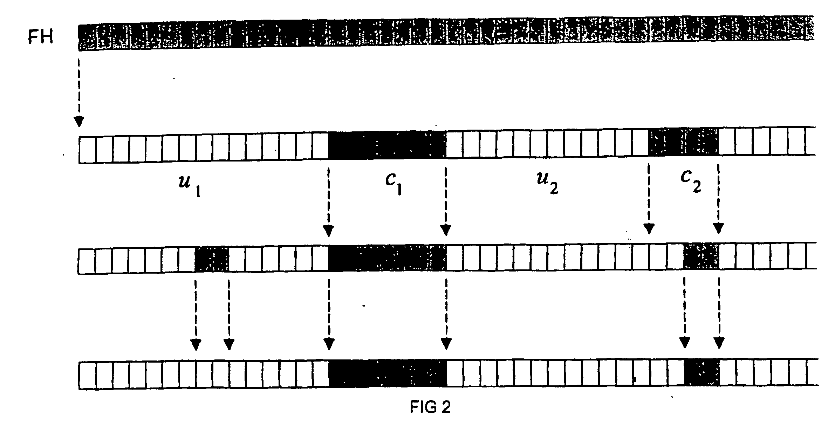

Ein unverändertes Feld oder u-Feld u-F wird definiert als zusammenhängender Bereich von mindestens m+1 unveränderten Bits. Die FIG 2 veranschaulicht diese Vorgehensweise anhand einer Folge von Headern, wobei zunächst der komplette Header FH in der ersten Zeile gezeigt. In den weiteren Zeilen sind nachfolgende Header gezeigt, wobei veränderte Bits dunkel dargestellt sind. Damit erfolgt eine Aufteilung in entsprechende Felder u-F und c-F, wobei sich deren Positionen und längen ändern. Die Positionen der veränderten und unveränderten Felder werden prädiziert, was durch Pfeile angedeutet ist. Gezeigt sind dazu jeweils zwei veränderte Felder c1, c2 und zwei unveränderte Felder u1, u2.

Für die eigentliche Codierung werden die Positionen der Felder von den Positionen der Felder des Vorgänger-Headers prädiziert. Für jede prädizierte Position wird ein Merkmal M (z.B. ein Bit) übertragen, das signalisiert, ob sich die Position geändert hat.

Der Code für ein Feld kann dazu beispielsweise folgendermaßen aussehen:

Bei unveränderter Position:

| u-Feld | Wert M=0 | (1 Bit) |
|--------|----------|---------|
| c-Feld | Wert M=0 | (1 Bit) |
|        | und Inhalt des geänderten Teils (uncodiert) | |

Bei veränderter Position:

| Für u-Feld oder c-Feld | |
|---|---|
| Wert M=1, | (1 Bit) |
| Länge des unveränderten Teils | (Längencode) |
| Länge des geänderten Teils | (Längencode) |
| Inhalt des geänderten Teils | (uncodiert) |
| Rest des Feldes in gleicher Weise | |

Der Längencode ist dabei z.B. folgendermaßen definiert: Der Längencode gibt die Länge des Feldes in Bit an. Die Anzahl der notwendigen Bits zur Codierung der Feldlänge ergeben sich aus dem Wertebereich entsprechend der folgenden Berechnungsvorschrift mittels des Logarithmus zur Basis 2:

$$\text{Anzahl der Bits} = [\log_2 (\text{Wertebereich - m})]$$

Die eckigen Klammern symbolisieren dabei, das der ermittelte Wert auf den nächsthöheren ganzzahligen Wert bzw. Integer-Wert gerundet wird.

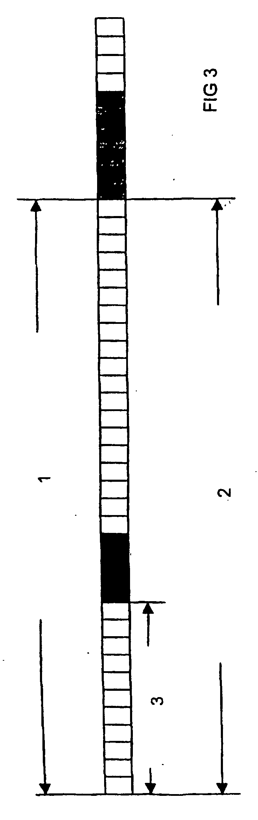

Der Wertebereich ist die Menge der zur Beschreibung der Länge notwendigen Zahlen. Dieser hängt von der Größe des Feldes ab. Die FIG 3 zeigt dazu ebenfalls zur Veranschaulichung eine Prinzipdarstellung des Codes für die Feldlänge. Ein Bereich 1 kennzeichnet ein als unverändert prädiziertes Feld u-F. Der Bereich 2 gibt den Wertebereich, also die besagte Menge der zur Beschreibung der Länge notwendigen Zahlen an. Der Bereich 3 schließlich signalisiert eine tatsächliche Anzahl von unveränderten Bits im Bereich 1.

Beispiel: Soll innerhalb eines Feldes der Länge 20 eine neue Position übermittelt werden, benötigt man dazu 5 Bits.

Die Codiereffizienz kann durch folgende Variante weiter gesteigert werden, wenn man davon ausgeht, dass bei gleichverteilter Wahrscheinlichkeit der Werte der c-Felder die Wahrscheinlichkeit für die Änderung eines Bits 50% beträgt. Damit ändern sich die Positionen der c-Felder (die Feldränder) ebenso häufig und müssten in jedem zweiten Fall neu codiert werden.

Um dies zu vermeiden, sollen die c-Felder um ein Nachbarbit erweitert werden, falls die Codierung dieses Bits weniger aufwendig ist, als die Codierung der geänderten Position. Dies ist der Fall, wenn

$$[\log_2 (\text{wertebereich} - m)] >= 2$$

beträgt.

In den meisten Protokollen liegt die Information in Bytes segmentiert vor. Das vorgestellte Verfahren kann ebenso auf Bytes statt Bits als kleinste Codiereinheit angewandt werden. Die Feldlängen werden dazu in Einheiten von Bytes berechnet, was zu kleineren Wertebereichen und effektiverer Codierung führt. In diesem Fall verzichtet man auf die Erweiterung der c-Felder um ein Nachbarelement. Nachteilig ist dabei aber, dass für den Fall, dass sich nur 1 Bit ändert, das gesamte Byte erneuert werden muss.

Der Algorithmus lässt sich unverändert auf eine differentielle Codierung 2. Ordnung, wie sie aus dem eingangs dargestellten Stand der Technik bekannt ist, ebenfalls anwenden.

Das beschriebene Verfahren gemäß der Erfindung kann darüber hinaus auch auf einen gesicherten Header-Strom aufsetzten. Beispielsweise werden Checksummen mitcodiert und können nach der Decodierung ausgewertet werden. Weiter lässt sich der komprimierte Datenstrom nach Bedarf mit Fehlerschutzmechanismen kombinieren.

Das Verfahren hat somit das Potential für einen neuen Standard zur Kompression von Netzprotokoll-Headern. Es ist universell anwendbar auf einzelne Header, kombinierte oder getunnelte Header.

**Patentansprüche**

1. Verfahren zur Kompression von Header-Informationen in Netzwerkprotokollen mit folgenden Schritten:

   - Übertragung eines vollständigen Headers (FH) beim Verbindungsaufbau sowie senderseitige und empfängerseitige Verwendung dieses Headers als Referenz,
   - Codierung durch senderseitiges Segmentieren jedes weiteren Headers in veränderte Felder (c-F; c1, c2) und unveränderte Felder (u-F; u1, u2) gegenüber dem jeweils vorangehenden Header, wobei ein zusammenhängender Bereich, der veränderte Symbole und Intervalle von höchstens m unveränderten Symbolen aufweist, als verändertes Feld (c-F) klassifiziert wird und ein zusammenhängender Bereich von mindestens m+1 unveränderten Symbolen als unverändertes Feld (u-F) klassifiziert wird,
   - Prädizieren der Positionen dieser Felder (u-F, c-F) von den Feldern des vorangehenden Headers,
   - differentielle Übermittlung des aktuellen Headers, indem für jede prädizierte Position ein Merkmal (M) übertragen wird, das signalisiert, ob sich eine Position geändert hat.

2. Verfahren zur Kompression von Header-Informationen in Netzwerkprotokollen nach Anspruch 1, wobei für Intervalle von höchstens m unveränderten Symbolen zur Klassifizierung als verändertes Feld (c-F) ein Wert m = 2 gewählt wird.

3. Verfahren zur Kompression von Header-Informationen in Netzwerkprotokollen nach Anspruch 1 oder 2, wobei im Bedarfsfall in vorgebbaren Abständen während einer Übertragung erneut ein vollständiger Header (FH) übermittelt wird, der senderseitig und empfängerseitig als neue Referenz dient.

4. Verfahren zur Kompression von Header-Informationen in Netzwerkprotokollen nach einem der vorangehenden Ansprüche, wobei neben jedem für eine prädizierte Position übertragenen Merkmal (M)

   - bei unveränderter Position im Fall eines veränderten Feldes (c-F) der Inhalt des geänderten Teils dieses Feldes übertragen wird und
   - bei veränderter Position im Fall eines veränderten Feldes (c-F) oder eines unveränderten Feldes (u-F) jeweils ein Längencode zur Beschreibung der Länge eines unveränderten Teils und/oder ein Längencode zur Beschreibung eines geänderten Teils sowie der Inhalt des geänderten Teils übertragen wird.

5. Verfahren zur Kompression von Header-Informationen in Netzwerkprotokollen nach Anspruch 4, wobei jedes für eine prädizierte Position übertragene Merkmal (M) ein Bit ist und jeder Längencode die Länge des jeweiligen Bereichs eines Feldes in einer Anzahl von Bits angibt, die nach

$$[\log_2 (\text{Bereich} - m)]$$

bemessen ist, wobei [x] eine Rundungsoperation darstellt, bei der die Zahl x auf den nächsthöheren Integer-Wert gerundet wird.

**6.** Verfahren zur Kompression von Header-Informationen in Netzwerkprotokollen nach Anspruch 4, wobei ein Byte als kleinste Codiereinheit dient, wobei jedes für eine prädizierte Position übertragene Merkmal (M) ein Byte ist und Feldlängen in Einheiten von Bytes bestimmt werden.

**7.** Verfahren zur Kompression von Header-Informationen in Netzwerkprotokollen nach einem der Ansprüche 1 bis 5, wobei im Fall einer geänderten Position veränderte Felder (c-F) um ein Nachbarsymbol ergänzt werden, falls eine Codierung dieses ergänzten Feldes weniger aufwendig ist als eine Codierung der geänderten Position.

**8.** Verfahren zur Kompression von Header-Informationen in Netzwerkprotokollen nach Anspruch 7, wobei eine Ergänzung um ein Nachbarsymbol stets erfolgt, wenn
[$\log_2$ (Anzahl der zur Beschreibung der Feldlänge notwendigen Zahlen - m)] >= 2 ist,
wobei [x] eine Rundungsoperation darstellt, bei der die Zahl x auf den nächsthöheren Integer-Wert gerundet wird.

**9.** Verfahren zur Kompression von Header-Informationen in Netzwerkprotokollen nach einem der vorangehenden Ansprüche, wobei in einem zu übertragenden gesicherten Headerstrom enthaltene fehlererkennende und/oder fehlerkorrigierende Codes, insbesondere Checksummen, mitkomprimiert werden.

**10.** Verfahren zur Kompression von Header-Informationen in Netzwerkprotokollen nach einem der vorhergehenden Ansprüche, wobei der komprimierte Datenstrom im Bedarfsfall um fehlererkennende und/oder fehlerkorrigierende Schutzmechanismen erweitert wird.

**11.** Verfahren zur Dekompression von nach einem der vorangehenden Ansprüche komprimierten Header-Informationen in Netzwerkprotokollen, bei dem ein jeweiliger nach einem der vorhergehenden Ansprüche komprimierter Header empfängerseitig anhand des vollständigen Headers (FH) und der differentiell übertragenen Informationen folgender Header, umfassend für jede von den Feldern des vorangehenden Headers prädizierte Position ein Merkmal, das signalisiert, ob sich die Position geändert hat, rekonstruiert wird.

**12.** Encoder zur Kompression von Header-Informationen in Netzwerkprotokollen, wobei der Encoder derart ausgestaltet ist, dass ein Verfahren nach einem der vorhergehenden Ansprüche 1 bis 10 durchführbar ist.

**13.** Decoder zur Dekompression von nach einem der vorangehenden Ansprüche 1 bis 10 komprimierten Header-Informationen in Netzwerkprotokollen, indem ein jeweiliger nach einem der Ansprüche 1 bis 10 komprimierter Header anhand des empfangenen vollständigen Headers (FH) und der differentiell übertragenen Informationen folgender Header, umfassend für jede von den Feldern des vorangehenden Headers prädizierte Position ein Merkmal, das signalisiert, ob sich die Position geändert hat, rekonstruierbar ist.

**14.** Sendeeinheit mit einem Encoder nach Anspruch 12.

**15.** Empfangseinheit mit einem Decoder nach Anspruch 13.

**Claims**

**1.** Method for compression of header information in network protocols having the following steps:

- transmission of a complete header (FH) during the setting up of a connection, as well as transmitter-end and receiver-end use of this header as a reference,
- coding by transmitter-end segmentation of each further header into changed fields (c-F; c1, c2) and unchanged fields (u-F; u1, u2) with respect to the respectively preceding header, with a cohesive area of changed symbols which has intervals of at most m unchanged symbols being classified as a changed field (c-F) and a cohesive area of at least m+1 unchanged symbols being classified as an unchanged field (u-F),
- prediction of the positions of these fields (u-F, c-F) from the fields of the preceding header,
- differential transmission of the current header by transmitting a feature (M) for each predicted position, which feature (M) signals whether a position has changed.

**2.** Method for compression of header information in network protocols according to Claim 1, with a value m=2 being chosen for intervals of at most m unchanged symbols for classification as a changed field (c-F).

3. Method for compression of header information in network protocols according to Claim 1 or 2, with a complete header (FH) being transmitted once again as required at intervals which can be predetermined during a transmission, and being used as a new reference at the transmitter end and at the receiver end.

4. Method for compression of header information in network protocols according to one of the preceding claims, with, in addition to each feature (M) which is transmitted for a predicted position,

   - if a changed field (c-F) occurs when the position has not changed, the content of the changed part of this field is transmitted, and
   - if a changed field (c-F) or an unchanged field (u-F) occurs when the position has changed, a length code is in each case transmitted in order to describe the length of an unchanged part, and/or a length code is transmitted in order to describe a changed part as well as the content of the changed part.

5. Method for compression of header information in network protocols according to Claim 4, with each feature (m) which is transmitted for a predicted position being one bit and each length code indicating the length of the respective area of a field in a number of bits, whose size is governed by

$$[\log_2 (\text{Area} - m)],$$

   [x] representing a rounding operation in which the number x is rounded up to the next-higher integer value.

6. Method for compression of header information in network protocols according to Claim 4, with one byte being used as the smallest coding unit, with each feature (M) which is transmitted for a predicted position being one byte, and with field lengths being determined in units of bytes.

7. Method for compression of header information in network protocols according to one of Claims 1 to 5, with changed fields (c-F) having an adjacent symbol added to them if the position has changed, when coding of this supplemented field is less complex than coding of the changed position.

8. Method for compression of header information in network protocols according to Claim 7, with an adjacent symbol always being added when
   $[\log_2 (\text{total of the numbers} - m \text{ required to describe the field length})]$ is greater than or equal to 2,
   [x] representing a rounding operation in which the number x is rounded up to the next-higher integer value.

9. Method for compression of header information in network protocols according to one of the preceding claims, with error-identifying and/or error-correcting codes which are contained in a protected header stream that is to be transmitted, in particular checksums, also being compressed.

10. Method for compression of header information in network protocols according to one of the preceding claims, with the compressed data stream having error-identifying and/or error-correcting protection mechanisms added to it when required.

11. Method for decompression of header information, which has been compressed in accordance with one of the preceding claims, in network protocols, in which a respective header which has been compressed in accordance with one of the above claims is reconstructed at the receiver end on the basis of headers which follow the complete header (FH) and the differentially transmitted information, comprising, for each position predicted by the fields of the preceding header, a feature which signals whether the position has changed.

12. Encoder for compression of header information in network protocols, with the encoder being constructed such that a method according to one of the preceding Claims 1 to 10, can be carried out.

13. Decoder for decompression of header information, which has been compressed in accordance with one of the preceding Claims 1 to 10, in network protocols, in that a respective header which has been compressed in accordance with one of Claims 1 to 10 can be reconstructed on the basis of headers which follow the received complete header (FH) and the differentially transmitted information, comprising, for each position predicted by the fields of the preceding header, a feature which signals whether the position has changed.

**14.** Transmitting unit having an encoder according to Claim 12.

**15.** Receiving unit having a decoder according to Claim 13.

## Revendications

**1.** Procédé de compression d'informations d'en-têtes dans des protocoles de réseau, comprenant les étapes suivantes:

- transmission d'un en-tête complet (FH) lors de l'établissement de la connexion et utilisation de cet en-tête, côté émetteur et côté récepteur, en tant que référence;
- codage par segmentation, côté émetteur, de chaque en-tête additionnel en champs modifiés (c-F; c1, c2) et en champs non modifiés (u-F; u1, u2) par rapport à l'en-tête respectivement précédent, une plage cohérente comportant des symboles modifiés et des intervalles de maximum m symboles non modifiés étant classée en tant que champ modifié (c-F) et une plage cohérente d'au moins m+1 symboles non modifiés étant classée en tant que champ non modifié (u-F);
- prédiction des positions de ces champs (u-F, c-F) par les champs de l'en-tête précédent;
- transmission différentielle de l'en-tête actuel par transmission, pour chaque position prédite, d'une caractéristique (M) qui signale si une position s'est modifiée.

**2.** Procédé de compression d'informations d'en-têtes dans des protocoles de réseau selon la revendication 1, une valeur m = 2 étant, pour des intervalles de maximum m symboles non modifiés, sélectionnée pour la classification en tant que champ modifié (c-F).

**3.** Procédé de compression d'informations d'en-têtes dans des protocoles de réseau selon la revendication 1 ou 2, un en-tête complet (FH), lequel sert de nouvelle référence côté émetteur et côté récepteur, étant de nouveau transmis, en cas de besoin, pendant une transmission, à intervalles prédéterminables.

**4.** Procédé de compression d'informations d'en-têtes dans des protocoles de réseau selon l'une des revendications précédentes, étant transmis, outre chaque caractéristique (M) transmise pour une position prédite,

- en cas de position non modifiée dans le cas d'un champ modifié (c-F): le contenu de la partie modifiée de ce champ et,
- en cas de position modifiée dans le cas d'un champ modifié (c-F) ou d'un champ non modifié (u-F): respectivement un code longueur pour la description de la longueur d'une partie non modifiée et/ou un code longueur pour la description d'une partie modifiée ainsi que le contenu de la partie modifiée.

**5.** Procédé de compression d'informations d'en-têtes dans des protocoles de réseau selon la revendication 4, chaque caractéristique (M) transmise pour une position prédite étant un bit et chaque code longueur indiquant la longueur de la plage respective d'un champ en un nombre de bits, laquelle est dimensionnée d'après

$$[\log_2 (\text{plage} - m)],$$

[x] représentant une opération d'arrondissement dans laquelle le nombre x est arrondi à la valeur entière directement supérieure.

**6.** Procédé de compression d'informations d'en-têtes dans des protocoles de réseau selon la revendication 4, un octet servant de plus petite unité de codage, chaque caractéristique (M) transmise pour une position prédite étant un octet et des longueurs de champs étant déterminées en unités d'octets.

**7.** Procédé de compression d'informations d'en-têtes dans des protocoles de réseau selon l'une des revendications 1 à 5, des champs modifiés (c-F) étant, dans le cas d'une position modifiée, complétés par un symbole voisin au cas où un codage de ce champ complété est moins complexe qu'un codage de la position modifiée.

**8.** Procédé de compression d'informations d'en-têtes dans des protocoles de réseau selon la revendication 7, une complétion par un symbole voisin étant toujours opérée lorsqu'on a [$\log_2$ (nombre des chiffres nécessaires pour décrire la longueur de champ - m)] >=2,
[x] représentant une opération d'arrondissement dans laquelle le nombre x est arrondi à la valeur entière directement supérieure.

**9.** Procédé de compression d'informations d'en-têtes dans des protocoles de réseau selon l'une des revendications précédentes, des codes, en particulier des sommes de contrôle, détectant des erreurs et/ou corrigeant des erreurs et contenus dans un flux d'en-têtes sécurisé à transmettre, étant co-comprimés.

**10.** Procédé de compression d'informations d'en-têtes dans des protocoles de réseau selon l'une des revendications précédentes, le flux de données comprimé étant élargi, en cas de besoin, par des mécanismes de protection détectant des erreurs et/ou corrigeant des erreurs.

**11.** Procédé de décompression, dans des protocoles de réseau, d'informations d'en-têtes comprimées selon l'une des revendications précédentes, dans lequel est reconstruit, côté récepteur, un en-tête respectif, comprimé selon l'une des revendications précédentes, à l'aide de l'en-tête complet (FH) et des informations d'en-têtes suivants transmises différentiellement, comprenant, pour chaque position prédite par les champs de l'en-tête précédent, une caractéristique qui signale si la position s'est modifiée.

**12.** Encodeur pour comprimer des informations d'en-têtes dans des protocoles de réseau, l'encodeur étant réalisé de manière telle qu'un procédé selon l'une des revendications 1 à 10 peut être exécuté.

**13.** Décodeur pour décomprimer, dans des protocoles de réseau, des informations d'en-têtes comprimées selon l'une des revendications précédentes 1 à 10, par la possibilité de reconstruire un en-tête respectif, comprimé selon l'une des revendications 1 à 10, à l'aide de l'en-tête complet (FH) reçu et des informations d'en-têtes suivants transmises différentiellement, comprenant, pour chaque position prédite par les champs de l'en-tête précédent, une caractéristique qui signale si la position s'est modifiée.

**14.** Unité d'émission comprenant un encodeur selon la revendication 12.

**15.** Unité de réception comprenant un décodeur selon la revendication 13.

```
4500 0208 ea94 4000 ef11 61cc cdbd c802 c31e e4a4 f616 1b3a 01f4 9722 01ec 0072 5a10 6c01 2437 0
4500 0212 ea95 4000 ef11 61c1 cdbd c802 c31e e4a4 f616 1b3a 01fe 5beb 000a 047e 6200 000b 4013 0
4500 0208 ea96 4000 ef11 61ca cdbd c802 c31e e4a4 f616 1b3a 01f4 254e 01ec 0074 5a10 6c01 25b5 0
4500 0208 ea97 4000 ef11 61c9 cdbd c802 c31e e4a4 f616 1b3a 01f4 74ff 01ec 0075 5a10 6c01 2674 0
4500 0208 ea98 4000 ef11 61c8 cdbd c802 c31e e4a4 f616 1b3a 01f4 2a5a 01ec 0076 5a10 6c01 2733 0
4500 0208 ea99 4000 ef11 61c7 cdbd c802 c31e e4a4 f616 1b3a 01f4 0924 01ec 0077 5a10 6c01 27f2 0
```

FIG 1

FIG 2

FIG 3